# EUROPÄISCHE PATENTSCHRIFT

(11) **EP 0 621 696 B1**
(45) Veröffentlichungstag und Bekanntmachung des Hinweises auf die Patenterteilung: **04.03.1998**
(21) Anmeldenummer: 94200982.0
(22) Anmeldetag: 12.04.1994
(51) Int. Cl.: H03K 21/38

(54) **Schnell rücksetzbare Zählanordnung**
Counting device with fast reset
Dispositif de comptage à remise rapide à l'état initial

(30) Priorität: 17.04.1993 DE 4312561
(43) Veröffentlichungstag der Anmeldung: 26.10.1994
(73) Patentinhaber: Philips Patentverwaltung GmbH, 22335 Hamburg (DE); PHILIPS ELECTRONICS N.V., 5621 BA Eindhoven (NL)
(72) Erfinder: Ibenthal, Achim, c/o Philips Patentverwaltung GmbH, D-20097 Hamburg (DE)
(74) Vertreter: von Laue, Hanns-Ulrich, Dipl.-Ing.

(56) Entgegenhaltungen:
- DE-A- 3 345 724
- Keine einschlägigen Dokumente gefunden

## Beschreibung

Die Erfindung betrifft eine schnell rücksetzbare Zählanordnung mit einem Zähler (1), dem eingangsseitig ein Zähltakt zugeführt wird und dessen Ausgangssignal einem ersten, mit dem Zähltakt getakteten Register (2) und einem zweiten, mit einem Rücksetzsignal getakteten Register (3) zugeführt wird, und mit einer Überlagerungsstufe (4), mittels derer das Ausgangssignal des zweiten getakteten Registers (3) von dem Ausgangssignal des ersten getakteten Registers (2) subtrahiert wird und die das Ausgangssignal der Zählanordnung liefert.

Für viele Anwendungen werden taktgenaue Zähler benötigt, die schnell rücksetzbar sind, die also nach einem Rücksetzvorgang mit dem nächsten Takt weiterzählen. Derartige Zähler werden beispielsweise für digitale Fernsehsignal-Anwendungen oder auch für digitale Signalprozessoren benötigt.

Aus der DE-OS 33 45 724 ist eine Anordnung zum Erzeugen eines fehlerkompensierten Positionsanzeigewertes bekannt, bei der anstelle des Rücksetzens eines Zählers ein zwischengespeicherter Zählerstand in ein Register beschrieben wird, dessen Inhalt dann vom aktuellen Zählerstand abgezogen wird.

Es ist Aufgabe der Erfindung, eine schnell rücksetzbare Zählanordnung anzugeben. welche geeignet ist, Signale mit möglichst hoher Taktfrequenz zu zählen.

Diese Aufgabe ist dadurch gelöst, daß der Zähler (1) als modulo-m-Zähler ausgelegt ist und aus mehreren parallelgeschalteten Teilzählern (11, 12, 13, ..., 15) aufgebaut ist, denen der durch die Anzahl der Teilzähler geteilte Zähltakt zugeführt wird, die jeweils um einen Takt zueinander verschoben arbeiten und deren Ausgangssignale mittels eines Multiplexers (17) zusammengeführt werden.

Bei relativ hohen Frequenzen des Zähltaktes ist eventuell ein Zähler nicht ausreichend; es werden daher mehrere parallelgeschaltete Teilzähler aufgebaut. Daher ist erfindungsgemäß vorgesehen, daß der Zähler aus mehreren parallelgeschalteten Teilzählern aufgebaut ist, denen der durch die Anzahl der Teilzähler geteilte Zähltakt zugeführt wird, die jeweils um einen Takt zueinander verschoben arbeiten und deren Ausgangssignale mittels eines Multiplexers zusammengeführt werden.

Die einzelnen Teilzähler können können langsamer sein, da sie nur mit einem n-tel der Taktfrequenz des Zähltaktes arbeiten müssen. Der Rücksetzvorgang für die erfindungsgemäße schnell rücksetzbare Zählanordnung mittels der beiden Register ist auch für diese Anordnung unverändert, wobei die beiden Register dem Multiplexer nachgeschaltet sind.

Bei dieser Zählanordnung muß der Zähler nicht selbst zurückgesetzt werden. Vielmehr wird bei Auftreten des Rücksetzsignals der Ausgangswert des Zählers in das zweite Register geladen. Mit dem nächsten Takt wird das Ausgangssignal des zweiten Registers von dem des ersten Registers subtrahiert. Somit beginnt dann das Ausgangssignal der Zählanordnung, nämlich das Ausgangssignal der Überlagerungsstufe, mit diesem Takt wieder bei Null und ist damit zurückgesetzt.

Dieser Vorgang wiederholt sich mit jedem neuem Auftreten des Rücksetzsignals, mit dem beim nächsten Takt des Zähltaktes das Ausgangssignal wieder zurückgesetzt wird.

Auf diese Weise gelingt das Rücksetzen zwischen zwei Zähltakten, wobei der Zähler ungestört weiterzählen kann und also keine Probleme durch das Rücksetzen auftreten.

Der Zähler ist als modulo-m-Zähler ausgelegt. Der Zähler selbst zählt dann in einer Zählschleife, die m-Takte umfaßt. Für den Rücksetzvorgang mittels der beiden Register ändert dies jedoch nichts, so daß die schnell rücksetzbare Zählanordnung auch für derartige modulo-m-Zähler einsetzbar ist.

Die erfindungsgemäße Zählanordnung, kann, wie nach einer weiteren Ausgestaltung der Erfindung vorgesehen ist, vorteilhaft in einem Signalprozessor eingesetzt werden.

Beispielsweise zur Detektion der Position eines Bildpunktes einer Bildzeile eines digitalen Fernsehsignals ist die erfindungsgemäße Anordnung gut geeignet, da sie mit dem Beginn jeder neuen Bildzeile schnell zurückgesetzt werden kann, wobei der Zählvorgang nicht unterbrochen oder gestört wird. Somit wird eine sichere Detektion der Zeilenposition trotz des zuvor erfolgten Rücksetzvorganges erreicht.

Nachfolgend werden anhand der Zeichnung zwei Ausführungsbeispiele der Erfindung näher erläutert. Es zeigen:
Fig. 1 eine schnell rücksetzbare Zählanordnung mit einem Zähler und
Fig. 2 eine schnell rücksetzbare Zählanordnung, bei der der Zähler aus mehreren Teilzählern aufgebaut ist.

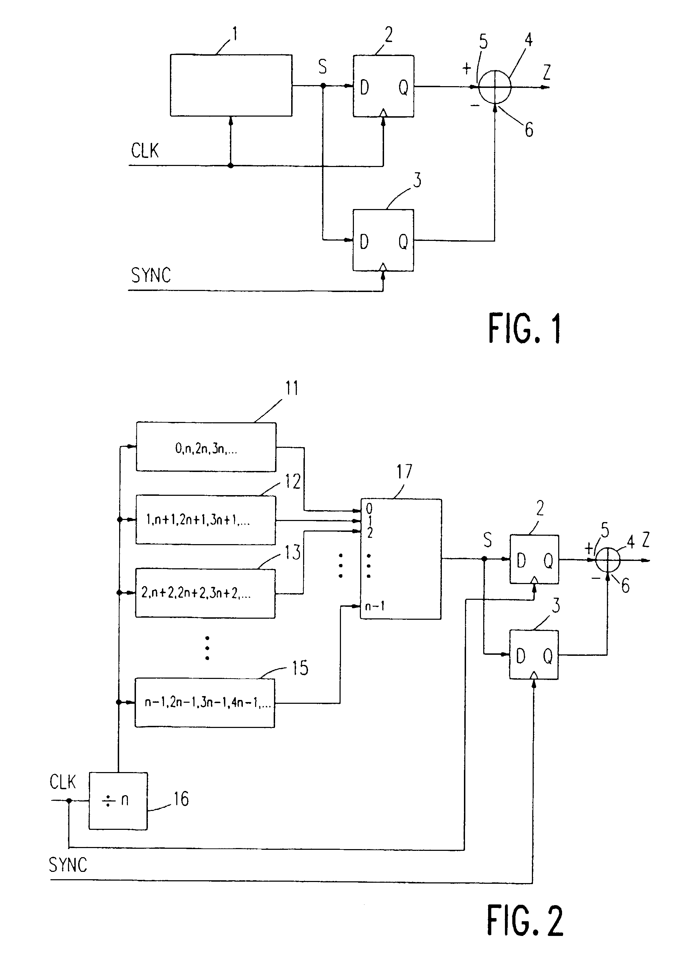

Eine in Fig. 1 in Form eines Blockschaltbildes dargestellte erste Ausführungsform der schnell rücksetzbaren Zählanordnung weist einen Zähler 1 auf, dem eingangsseitig ein Zähltakt CLK zugeführt wird. Das Ausgangssignal des Zählers 1, das in der Fig. mit S bezeichnet ist, gelangt auf ein erstes mit dem Zähltakt CLK getaktetes Register 2 und ein zweites mit einem Rücksetzsignal SYNC getaktetes Register 3.

Den Registern 2 und 3 ist eine Überlagerungsstufe nachgeschaltet, bei der es sich um einen Addierer oder einen Subtrahierer handeln kann. In dem Ausführungsbeispiel gemäß Fig. 1 ist ein Addierer 4 vorgesehen, der einen nicht-invertierenden Eingang 5 und einen invertierenden Eingang 6 aufweist. Dem nicht-invertierenden Eingang 5 ist das Ausgangssignal des Registers 2 und dem invertierenden Eingang 6 wird das Ausgangssignal des Registers 3 zugeführt.

Während des normalen Zählvorgangs wird mit jedem Zähltakt CLK der zuvor am Ausgang des Zählers 1 erscheinende Ausgangswert in das Register 2 übernommen und über die Überlagerungsstufe 4 an den Ausgang der Zählanordnung gegeben.

Mit dem ersten auftretenden Rücksetzvorgang, der mittels eines Impulses des Rücksetzsignals SYNC ausgelöst wird, wird der Wert des Ausgangssignals des Zählers 1 ebenfalls in das Register 3 übernommen. Nachfolgend erscheint dieser Wert am Ausgang des Registers 3 und damit auch am invertierenden Eingang 6 der Überlagerungsstufe 4.

Alle nachfolgenden Werte des Zählers 1 und damit auch mit dem nächsten Zähltakt die Ausgangswerte des ersten Registers 2 werden mittels der Überlagerungsstufe 4 um den Wert, der in dem Register 3 steht, verringert. Das Ausgangssignal des Registers 3 wird also vom Ausgangssignal des Registers 2 subtrahiert. Damit beginnt das Ausgangssignal der Überlagerungsstufe 4, das gleichzeitig das Ausgangssignal Z der gesamten Zähleranordnung darstellt, wieder mit Null. Es wird also mit jedem Auftreten eines Rücksetzimpulses des Rücksetzsignals SYNC ein Zählerstand in das Register 3 übernommen, der von den nachfolgenden Zählerständen subtrahiert wird, so daß nach jedem Rücksetzvorgang das Ausgangssignal der Zähleranordnung wieder auf Null zurückgesetzt wird.

Bei dem Zähler 1 kann es sich um einen modulo-m-Zähler handeln. Das Ausgangssignal der Zählanordnung ist dann ebenfalls ein modulo-m-Signal, das jedoch durch einen Impuls des Rücksetzsignals zurückgesetzt werden kann.

Eine in Fig. 2 dargestellte zweite Ausführungsform der Erfindung weist ebenfalls ein erstes Register 2, ein zweites Register 3 und eine Überlagerungsstufe 4 auf, die in gleicher Weise verschaltet sind wie die entsprechenden Elemente der Anordnung gemäß Fig. 1.

Der Zähler 1 gemäß der ersten Ausführungsform in Fig. 1 ist jedoch in der Ausführungsform gemäß Fig. 2 durch mehrere Teilzähler 11, 12, 13 und 15 aufgebaut. Das Taktsignal CLK wird in einem Teiler 16 durch einen Divisor n heruntergeteilt, wobei n gleich der Anzahl der Teilzähler 11 bis 15 ist. Sind beispielsweise vier Teilzähler vorgesehen, so wird jedem Teilzähler ein Zähltakt mit einem Viertel der Taktfrequenz des ursprünglichen Zähltaktes CLK zugeführt.

Diese Anordnung hat den Vorteil, daß die Teilzähler langsamer sein können als der Zähler 1 gemäß Fig. 1.

Die Ausgangssignale der Teilzähler 11 bis 15 der Anordnung gemäß Fig. 2 werden mittels eines Multiplexers 17 wieder zusammengeführt.

Insbesondere für eine derartige Zählerauslegung mit mehreren Teilzählern ist deren Rücksetzen problematisch, da erstens jeder Zähler einzeln zurückgesetzt werden muß und außerdem jeder Zähler phasenrichtig zurückgesetzt werden muß, da die Zähler um jeweils einen Zähltakt verschoben zueinander arbeiten.

Die erfindungsgemäße Zählanordnung ist auch für einen derartigen Zähler, der aus mehreren Teilzählern aufgebaut ist, in unveränderter Form geeignet. Die Fig. 2 zeigt, daß die beiden Register 2 und 3 sowie die Überlagerungsstufe 4 dem Ausgang des Multiplexers 17 nachgeschaltet sind. Die Arbeitsweise dieser Schaltungselemente ist identisch mit derjenigen der Schaltungsanordnung gemäß Fig. 1.

Zählanordnungen gemäß den Fig. 1 und 2 sind beispielsweise in digitalen Signalprozessoren vorteilhaft einsetzbar. Diese können beispielsweise für Zwecke der digitalen Fernsehsignalverarbeitung eingesetzt werden, wobei beispielsweise für diese Zählanordnungen zur Erkennung der Zeilenposition eines Bildpunktes innerhalb einer Bildzeile eines derartigen Fernsehsignals eingesetzt werden kann. Die Zähler 1 bzw. die Teilzähler 11 bis 15 zählen dabei den Takt, mit dem neue Bildpunkte auftreten. Die Zählanordnungen werden mittels eines am Beginn einer Bildzeile generierten Signals zurückgesetzt, das beispielsweise aus dem Horizontalsynchronsiganl gewonnen werden kann. Gerade für diese Einsatzzweck ist es von großem Vorteil, daß der Zählvorgang durch das Rücksetzen nicht gestört wird und somit unabhängig von dem Rücksetzvorang eine sichere Erkennung der Position eines jeden Bildpunktes einer Bildzeile vorgenommen werden kann.

## Patentansprüche

1. Schnell rücksetzbare Zählanordnung mit einem Zähler (1), dem eingangsseitig ein Zähltakt zugeführt wird und dessen Ausgangssignal einem ersten, mit dem Zähltakt getakteten Register (2) und einem zweiten, mit einem Rücksetzsignal getakteten Register (3) zugeführt wird, und mit einer Überlagerungsstufe (4), mittels derer das Ausgangssignal des zweiten getakteten Registers (3) von dem Ausgangssignal des ersten getakteten Registers (2) subtrahiert wird und die das Ausgangssignal der Zählanordnung liefert,
dadurch gekennzeichnet, daß der Zähler (1) als modulo-m-Zähler ausgelegt ist und aus mehreren parallelgeschalteten Teilzählern (11, 12, 13, ..., 15) aufgebaut ist, denen der durch die Anzahl der Teilzähler geteilte Zähltakt zugeführt wird, die jeweils um einen Takt zueinander verschoben arbeiten und deren Ausgangssignale mittels eines Multiplexers (17) zusammengeführt werden.

2. Verwendung der Zählanordnung gemäß Anspruch 1 in einem Signalprozessor.

3. Verwendung der Zählanordnung gemäß Anspruch 1 zur Detektion der Position eines Bildpunktes eines Bildsignals eines digitalen Fernsehsignals innerhalb einer Bildzeile, wobei das Rücksetzsignal den Anfang der Bildzeile angibt.

## Claims

1. A rapidly resettable counting device comprising a counter (1) to which a clock signal is applied at the input side and whose output signal is applied to a first register (2) clocked by the clock signal and to a second register (3) clocked by a reset signal, and comprising a summing stage (4) by means of which the output signal of the second clocked register (3) is subtracted from the output signal of the first clocked register (2), which stage supplies the output signal of the counting device.
characterized in that the counter (1) is a modulo-m counter, and the counter comprises a plurality of parallel-connected sub-counters (11, 12, 13, ..., 15) to which the clock signal divided by the number of sub-counters is applied, which sub-counters operate each shifted by one clock period, and the output signals of said sub-counters are combined by means of a multiplexer (17).

2. The use of the counting device as claimed in Claim 1 in a signal processor.

3. The use of the counting device as claimed in Claim 1 for detecting the position of a pixel of a picture signal of a digital television signal within a picture line, the reset signal indicating the beginning of the picture line.

## Revendications

1. Dispositif de comptage réinitialisable rapidement avec un compteur (1) auquel est amenée côté entrée une cadence de comptage et dont le signal de sortie est amené à un premier registre (2) cadencé avec la cadence de comptage et à un deuxième registre (3) cadencé avec un signal de réinitialisation et avec un étage de superposition (4) à l'aide duquel le signal de sortie du deuxième registre cadencé (3) est soustrait du signal de sortie du premier registre cadencé (2) et qui délivre le signal de sortie du dispositif de comptage,
caractérisé en ce que
le compteur (1) est conçu comme un compteur modulo-m et se compose de plusieurs compteurs partiels (11, 12, 13, ..., 15) montés en parallèle auxquels est amenée la cadence de comptage divisée par le nombre de compteurs partiels qui travaillent respectivement en décalage dune cadence l'un par rapport à l'autre et dont les signaux de sortie sont combinés à l'aide d'un multiplexeur (17).

2. Mise en oeuvre du dispositif de comptage, selon la revendication 1, dans un processeur de signaux.

3. Mise en oeuvre du dispositif de comptage, selon la revendication 1, pour la détection de la position d'un pixel d'un signal dimage d'un signal de télévision numérique à l'intérieur d'une ligne d'image, le signal de réinitialisation indiquant le début de la ligne d'image.
